# EUROPÄISCHE PATENTSCHRIFT

(11) **EP 2 656 087 B1**
(45) Veröffentlichungstag und Bekanntmachung des Hinweises auf die Patenterteilung: **26.03.2014**
(21) Anmeldenummer: 11785594.0
(22) Anmeldetag: 17.11.2011
(51) Int. Cl.: G01R 31/00, G01R 35/00, B60L 3/00, B60R 16/02

(54) **TEST EINER PRÜFEINRICHTUNG ZUM BESTIMMEN EINES SPANNUNGSZUSTANDES EINES HOCHVOLTBORDNETZES**
TEST OF A TESTING DEVICE FOR DETERMINING A VOLTAGE STATE OF A HIGH-VOLTAGE VEHICLE ELECTRICAL SYSTEM
ESSAI D'UN DISPOSITIF DE CONTRÔLE DESTINÉ À DÉTERMINER UN ÉTAT DE TENSION D'UN RÉSEAU DE BORD À HAUTE TENSION

(30) Priorität: 24.12.2010 DE 102010056235
(43) Veröffentlichungstag der Anmeldung: 30.10.2013
(73) Patentinhaber: Audi AG, 85045 Ingolstadt (DE)
(72) Erfinder: THÖMMES, Marco, 85049 Ingolstadt (DE)
(74) Vertreter: Herbst, Matthias Heinz
(86) Internationale Anmeldenummer: PCT/EP2011/005796
(87) Internationale Veröffentlichungsnummer: WO 2012/084102

(56) Entgegenhaltungen:
- DE-A1- 10 212 493
- DE-A1-102006 050 529
- DE-A1-102007 061 729
- DE-A1-102008 006 223

## Beschreibung

Die Erfindung betrifft ein Verfahren zum Testen einer Prüfeinrichtung zum Bestimmen eines Spannungszustandes eines Hochvoltbordnetzes eines Kraftwagens.

Kraftwagen mit elektrischem oder Hybridantrieb weisen leistungsstarke Spannungsquellen zum Versorgen elektrischer Antriebsaggregate mit Energie auf. Um die thermische Belastung eines solchen Hochvoltbordnetzes zu reduzieren, werden üblicherweise Betriebsspannungen von 400 V oder mehr verwendet, welche bei Berührung eine erhebliche Gefahr für Bedien- oder Wartungspersonal darstellen. Bei Reparatur- oder Wartungsarbeiten an solchen Kraftwagen muss daher der spannungsfreie Zustand des Hochvoltbordnetzes sichergestellt werden.

Üblicherweise ist hierzu eine Prüfeinrichtung vorgesehen, mittels welcher der Spannungszustand des Hochvoltbordnetzes festgestellt werden kann. Eine solche Prüfeinrichtung kann in den Kraftwagen integriert sein oder auch Bestandteil eines bei Wartungsarbeiten an den Kraftwagen anzuschließenden externen Prüfgerätes sein.

Wird mit einer solchen Prüfeinrichtung festgestellt, dass das Hochvoltbordnetz spannungsfrei ist, so muss zudem sichergestellt werden, dass diese Feststellung nicht auf einer Fehlfunktion der Prüfeinrichtung beruht. Üblicherweise wird daher der Spannungszustand beim Abschalten des Hochvoltbordnetzes beobachtet. Stellt man hierbei ein Absinken der Bordnetzspannung von der Betriebsspannung auf Null fest, so ist gesichert, dass die Prüfeinrichtung funktioniert und das Hochvoltbordnetz nun tatsächlich spannungsfrei ist.

Dies kann jedoch nur dann durchgeführt werden, wenn sich das Hochvoltbordnetz in einem betriebsbereiten Zustand befindet. Das ist jedoch bei Wartungs- oder Reparaturarbeiten nicht immer der Fall. In solchen Situationen entsteht daher eine zusätzliche Gefahr für das Wartungspersonal.

Beispielsweise kann das Hochvoltbordnetz aufgrund eines defekten Schützes spannungsfrei sein. Werden nun im Vertrauen auf den spannungsfreien Zustand Arbeiten am Bordnetz durchgeführt, ohne das Hochvoltbordnetz durch Öffnen eines Serviceschalters zuverlässig und dauerhaft spannungsfrei zu schalten, so kann es dazu kommen, dass das defekte Schütz wieder schließt, so dass das Hochvoltbordnetz wieder unter Spannung steht. Daher muss zusätzlich sichergestellt werden, dass der spannungsfreie Zustand des Hochvoltbordnetzes auch dauerhaft ist und auf dem Öffnen eines Serviceschalters oder einer ähnlichen, gewollten Unterbrechung des Stromkreises beruht.

Die DE 10 2006 050 529 A1 beschreibt ein Verfahren zum Überwachen von Schützen in Hochvoltbordnetzen, bei welchem durch Einspeisen einer Prüfspannung in das Hochvoltbordnetz ermittelt wird, ob ein Schütz geöffnet oder geschlossen ist.

Aus der DE 10 2007 061 729 A1 ist ein Verfahren zum Überwachen eines Hochvoltbordnetzes bekannt, bei welchem ein Messwert eines Stromsensors durch Vergleich mit errechneten Werten plausibilisiert wird.

Die DE 10 2008 006 223 A1 offenbart ein Verfahren zur Spannungsmessung, bei welcher eine Spannung und eine Referenzspannung gemessen und das Verhältnis der gemessenen Spannungen graphisch visualisiert wird.

Der vorliegenden Erfindung liegt somit die Aufgabe zugrunde, ein Verfahren der eingangs genannten Art bereitzustellen, welches eine zuverlässige Feststellung eines Spannungszustandes eines Hochvoltbordnetzes in einem Kraftwagen ermöglicht.

Diese Aufgabe wird durch ein Verfahren mit den Merkmalen des Patentanspruchs 1 gelöst.

Bei einem erfindungsgemäßen Verfahren zum Testen einer Prüfeinrichtung zum Bestimmen eines Spannungszustandes eines Hochvoltbordnetzes eines Kraftwagens, wird durch Einspeisen einer Prüfspannung in das Hochvoltbordnetz ein vorgegebener Spannungszustand im Hochvoltbordnetz hergestellt. Anschließend wird der von der Prüfeinrichtung bestimmte Spannungszustand mit dem vorgegebenen Spannungszustand verglichen.

Stimmen die Spannungszustände überein, so kann davon ausgegangen werden, dass die Prüfeinrichtung ordnungsgemäß funktioniert. Zeigt die Prüfeinrichtung nun bei einem anschließenden Öffnen eines Serviceschalters oder bei einer ähnlichen gewollten Unterbrechung des Hochvoltbordnetzes ein Absinken der Spannung im Hochvoltbordnetz auf Null an, so kann von einem gesichert spannungsfreien Zustand des Hochvoltbordnetzes ausgegangen werden, so dass Wartungs- und Reparaturarbeiten gefahrlos durchgeführt werden können.

Liegt dagegen eine Abweichung zwischen dem vorgegebenen und dem bestimmten Spannungszustand vor, so ist dies ein Hinweis auf eine Fehlfunktion der Prüfeinrichtung. Bei nachfolgenden Wartungs- und Reparaturarbeiten müssen daher besondere Sicherheitsmaßnahmen ergriffen werden. Eine fälschliche Einschätzung des Hochvoltbordnetzes als spannungsfrei kann so zuverlässig vermieden werden.

Bei einer bevorzugten Ausführungsform der Erfindung wird während des Einspeisens der Prüfspannung ein Stromfluss im Hochvoltbordnetz durch Öffnen eines Schalters unterbrochen und überprüft, ob die Spannung im Hochvoltbordnetz auf Null abfällt. Ist dies der Fall, so ist sichergestellt, dass das Hochvoltbordnetz physikalisch unterbrochen und dauerhaft spannungsfrei ist. Im Gegensatz zur üblichen Vorgehensweise kann dies auch dann gesichert festgestellt werden, wenn bereits eine andere Unterbrechung im Hochvoltbordnetz, beispielsweise durch eine defekte Komponente, vorliegt. Auch in solchen Situationen ist dann ein gefahrloses Arbeiten am Hochvoltbordnetz möglich.

Vorzugsweise wird bei einer Abweichung des bestimmten vom vorgegebenen Spannungszustand ein Signal erzeugt. Hierbei kann es sich um ein optisches oder akustisches Signal handeln. Mittels eines solchen Signals kann Bedien- oder Wartungspersonal zuverlässig vor einem möglicherweise unsicheren Zustand des Hochvoltbordnetzes gewarnt werden.

Zusätzlich oder alternativ hierzu ist es zweckmäßig, bei einer solchen Abweichung eine Information betreffend die Abweichung in einer Speichereinrichtung abzulegen. Diese Information kann bei späteren Wartungs- oder Reparaturarbeiten ausgelesen werden und als Warnung vor möglicherweise auftretenden Gefahren dienen. Das Abspeichern dieser Information zum späteren Auslesen ermöglicht zudem eine automatisierte Durchführung des Verfahrens unabhängig von bevorstehenden Wartungsarbeiten.

Besonders vorteilhaft ist es, das Verfahren vor jedem Abschaltvorgang des Hochvoltbordnetzes durchzuführen. Die Funktionsfähigkeit der Prüfeinrichtung wird so bereits im Normalbetrieb des Kraftwagens laufend überprüft, so dass bei Wartungsarbeiten zuverlässige Informationen über möglicherweise auftretende Probleme und Gefahren aus der Speichereinrichtung ausgelesen werden können.

Zusätzlich oder alternativ kann das Verfahren jedoch auch unmittelbar vor einer bevorstehenden Wartungs- und/oder Reparaturtätigkeit durchgeführt werden. Damit wird sichergestellt, dass seit dem letzten Test der Prüfeinrichtung kein neuer Fehler aufgetreten ist, so dass die gewonnenen Informationen über den Funktionszustand der Prüfeinrichtung besonders zuverlässig sind.

Bei einer weiteren bevorzugten Ausführungsform der Erfindung beträgt die eingespeiste Spannung weniger als 60 V. Derart niedrige Spannungen stellen bei Berührung kein Gesundheitsrisiko dar, so dass das Verfahren auch während bereits laufender Wartungsarbeiten am Hochvoltbordnetz sicher durchgeführt werden kann.

Zweckmäßigerweise wird die Prüfspannung mittels eines Spannungswandlers aus einem Niederspannungsbordnetz des Kraftwagens bereitgestellt. Damit kann die Prüfspannung auch dann ohne externe Hilfsmittel in das Hochspannungsbordnetz des Kraftwagens eingespeist werden, wenn das Hochspannungsbordnetz aufgrund eines Defektes einer Komponente nicht funktionsfähig ist. Zusätzliche Bauteile sind hierfür nicht notwendig, da ein solcher Spannungswandler, der das Hochvoltbordnetz mit dem Niedervoltbordnetz, meist einem 12V-Netz, verbindet, üblicherweise ohnehin vorhanden ist.

Alternativ kann die Prüfspannung auch mittels einer externen Spannungsquelle bereitgestellt werden. Diese wird zweckmäßigerweise mittels eines berührungsgeschützten Steckers mit dem Hochvoltbordnetz verbunden, um bei unbekanntem Zustand des Hochvoltbordnetzes das Bedienpersonal nicht zu gefährden. Die Verwendung einer externen Spannungsquelle ermöglicht eine Durchführung des Verfahrens auch bei ausgefallenem Niedervoltbordnetz.

Bei einer weiteren Ausführungsform der Erfindung wird die Prüfspannung von einer Vorladeschaltung eines Energiespeichers des Hochvoltbordnetzes bereitgestellt. Solche Energiespeicher dienen der Stabilisierung des Hochvoltbordnetzes bei Ein- und Ausschaltvorgängen. Es kann sich hierbei beispielsweise um Kondensatoren handeln. Die Vorladeschaltung wird so bezeichnet, da sie solche Kondensatoren vorlädt, sie dient also zum Erzeugen eines vorgegebenen Ladezustands des Energiespeichers beim Aktivieren des Bordnetzes und ist geeignet, Spannungen im Bereich der gewünschten Prüfspannung bereitzustellen. Zusätzliche Bauteile werden daher vorteilhafterweise nicht benötigt.

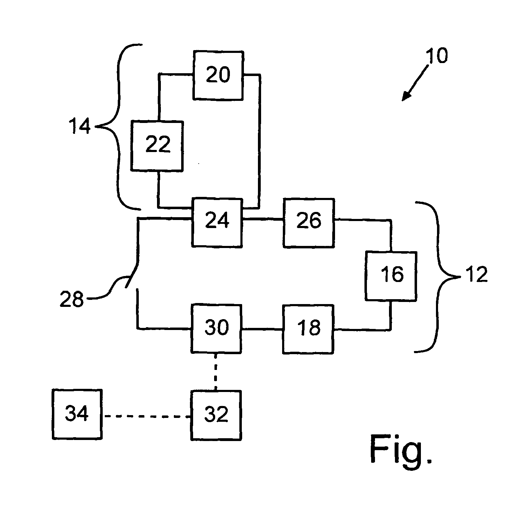

Im Folgenden wird die Erfindung und ihre Ausführungsformen anhand der Zeichnung näher erläutert. Die einzige Figur zeigt hierbei eine schematische Darstellung eines Bordnetzes eines Kraftwagens.

Ein im Ganzen mit 10 bezeichnetes Bordnetz eines Kraftwagens ist in ein Hochvoltbordnetz 12 und ein Niedervoltbordnetz 14 aufgeteilt. Im Hochvoltbordnetz 12 wird durch eine Spannungsquelle 16 eine Spannung von üblicherweise 400 V bis 650 V zum Betreiben leistungsstarker Verbraucher 18, wie beispielsweise von Antriebsaggregaten elektrischer oder hybrider Kraftwagen bereitgestellt.

Im Niedervoltbordnetz 14 stellt eine weitere Spannungsquelle 20 eine Spannung von üblicherweise 12 V für leistungsschwache Verbraucher 22, beispielsweise Steuergeräte oder dgl. zur Verfügung. Das Hochvoltbordnetz 12 ist ferner über einen Gleichspannungswandler 24 mit dem Niedervoltbordnetz 14 elektrisch gekoppelt.

Da die hohe Spannung im Hochvoltbordnetz 12 eine Gefahr für Bedien- und Wartungspersonal darstellt, ist ferner ein Schütz 26 zum Abtrennen der Spannungsquelle 16 vom Hochvoltbordnetz 12 vorgesehen. Durch das Schütz 26 wird bei Fehlfunktionen sowie beim Deaktivieren des Kraftwagens das Hochvoltbordnetz 12 unterbrochen. Bei Wartungs- und Reparaturarbeiten kann das Hochvoltbordnetz 12 ferner durch einen sogenannten Serviceschalter 28 manuell und unabhängig von der Steuerung des Schützes 26 unterbrochen werden. An Stelle des Serviceschalters 28 kann auch ein Stecker treten, der zum Unterbrechen des Hochvoltbordnetzes 12 manuell gezogen wird. Das Ziehen des Steckers bzw. Betätigen des Schalters kann dabei eine Leitung des Hochvoltbordnetzes 12 direkt unterbrechen oder aber eine Steuerleitung des Schützes 26 trennen, so dass dieses nicht mehr mit Strom versorgt wird und sich öffnet.

Um die Sicherheit des Wartungspersonals bei Arbeiten am Hochvoltbordnetz 12 zu gewährleisten, muss der Spannungszustand des Hochvoltbordnetzes 12 zusätzlich überwacht werden. Hierfür ist ein Spannungssensor 30 vorgesehen, mittels welchem vor einer Arbeitstätigkeit überprüft werden kann, ob das Hochvoltbordnetz 12 tatsächlich spannungsfrei ist. Die Messwerte des Spannungssensors 30 werden von einem Steuergerät 32 ausgelesen und an ein externes Diagnosegerät 34 übermittelt. Auch eine zusätzliche oder alternative Übermittlung der Messwerte an ein internes Diagnosegerät des Kraftwagens ist möglich.

Wichtig ist dabei, festzustellen, ob der spannungsfreie Zustand des Hochvoltbordnetzes 12 tatsächlich durch das Öffnen des Serviceschalters 28 verursacht wird. Ist dies nicht der Fall, beispielsweise wenn das Hochvoltbordnetz 12 bereits vor dem Öffnen des Serviceschalters 28 aufgrund eines Defekts spannungsfrei ist, könnte es vorkommen, dass bei geschlossenem Serviceschalter 28 Arbeiten am Hochvoltbordnetz 12 vorgenommen werden. Wird dabei der Defekt beseitigt, so stünde das Hochvoltbordnetz 12 wieder unter Spannung, was ein beträchtliches Risiko für das Wartungspersonal darstellt.

Um dies zu vermeiden, wird üblicherweise die vom Spannungssensor 30 gemessene Spannung beim Öffnen des Serviceschalters beobachtet. Nur wenn ein Absinken der gemessenen Spannung von der normalen Betriebsspannung des Hochvoltbordnetzes 12 auf Null beobachtet wird, kann sicher am Bordnetz 10 gearbeitet werden.

Dies ist jedoch nicht möglich, wenn das Hochvoltbordnetz bereits bei geschlossenem Serviceschalter 28 spannungsfrei ist. In diesem Fall wird daher eine Prüfspannung von weniger als 60 V mittels des Spannungswandlers 24 aus dem Niedervoltbordnetz 14 in das Hochvoltbordnetz 12 eingespeist. Wenn nun beim Öffnen des Serviceschalters 28 ein Abfallen der vom Sensor 30 gemessenen Spannung von der Prüfspannung auf Null festgestellt wird, ist der gewünschte sichere Zustand des Hochvoltbordnetzes sichergestellt.

Das Einspeisen einer Prüfspannung aus dem Niedervoltbordnetz 14 kann zudem zur automatischen Diagnose des Funktionszustands des Spannungssensors 30 verwendet werden. Hierzu wird im spannungsfreien Zustand des Hochvoltbordnetzes 12 - beispielsweise bei geöffnetem Schütz 26 - eine vorgegebene Prüfspannung eingespeist und die vom Spannungssensor 30 gemessene Spannung mit dieser Prüfspannung verglichen. Bei einer Abweichung der gemessenen von der eingespeisten Spannung wird der Spannungssensor 30 als defekt betrachtet und eine entsprechende Information im Steuergerät 32 gespeichert. Diese kann bei der nächsten Wartung des Kraftwagens durch das externe Diagnosegerät 32 ausgelesen werden, so dass das Wartungspersonal sofort über mögliche Gefahren informiert werden kann. Ein solcher automatisierter Test des Spannungssensors kann beispielsweise jedes Mal durchgeführt werden, wenn der Kraftwagen deaktiviert wird.

## Patentansprüche

1. Verfahren zum Testen einer Prüfeinrichtung (30) zum Bestimmen eines Spannungszustandes eines Hochvoltbordnetzes (12) eines Kraftwagens, bei welchem ein spannungsfreier Zustand des Hochvoltbordnetzes (12) hergestellt und anschließend durch Einspeisen einer Prüfspannung in das Hochvoltbordnetz (12) ein vorgegebener Spannungszustand im Hochvoltbordnetz (12) hergestellt wird, der Spannungszustand mittels der Prüfeinrichtung (30) bestimmt wird und der von der Prüfeinrichtung (30) bestimmte Spannungszustand mit dem vorgegebenen Spannungszustand verglichen wird,
**dadurch gekennzeichnet, dass**
während des Einspeisens der Prüfspannung ein Stromfluss im Hochvoltbordnetz (12) zwischen einem Einspeisepunkt der Prüfspannung und der Prüfeinrichtung (30) durch Öffnen eines Serviceschalters (28) unterbrochen wird und überprüft wird, ob die Spannung im Hochvoltbordnetz (12) auf Null abfällt.

2. Verfahren nach Anspruch 1,
**dadurch gekennzeichnet, dass**
bei einer Abweichung des bestimmten vom vorgegebenen Spannungszustand ein Signal erzeugt wird.

3. Verfahren nach einem der Ansprüche 1 oder 2,
**dadurch gekennzeichnet, dass**
bei einer Abweichung des bestimmten vom vorgegebenen Spannungszustand eine Information betreffend die Abweichung in einer Speichereinrichtung abgelegt wird.

4. Verfahren nach Anspruch 3,
**dadurch gekennzeichnet, dass**
das Verfahren automatisch vor-jedem Abschaltvorgang des Hochvoltbordnetzes (12) durchgeführt wird.

5. Verfahren nach einem der Ansprüche 1 bis 4,
**dadurch gekennzeichnet, dass**
das Verfahren unmittelbar vor einer bevorstehenden Wartungs-und/oder Reparaturtätigkeit durchgeführt wird.

6. Verfahren nach einem der Ansprüche 1 bis 5,
**dadurch gekennzeichnet, dass**
die Prüfspannung weniger als 60 V beträgt.

7. Verfahren nach einem der Ansprüche 1 bis 6,
**dadurch gekennzeichnet, dass**
die Prüfspannung mittels eines Spannungswandlers (24) aus einem Niedervoltbordnetz (14) des Kraftwagens bereitgestellt wird.

8. Verfahren nach einem der Ansprüche 1 bis 6,
**dadurch gekennzeichnet, dass**
die Prüfspannung mittels einer externen Spannungsquelle bereitgestellt wird, welche mittels einer berührungsgeschützten Steckverbindung mit dem Hochvoltbordnetz (12) verbunden wird.

9. Verfahren nach einem der Ansprüche 1 bis 6,
**dadurch gekennzeichnet, dass**
die Prüfspannung mittels einer Vorladeschaltung für einen Energiespeicher des Hochvoltbordnetzes (12) bereitgestellt wird.

## Claims

1. Method for testing a testing device (30) for determining a voltage state of a high-voltage on-board power system (12) of a motor vehicle, in which a voltage-free state of the high-voltage on-board power system (12) is produced, a predetermined voltage state is then produced in the high-voltage on-board power system (12) by feeding a test voltage into the high-voltage on-board power system (12), the voltage state is determined by the testing device (30), and the voltage state determined by the testing device (30) is compared with the predetermined voltage state,
**characterised in that**,
during feeding of the test voltage, a current flow in the high-voltage on-board power system (12) is interrupted between a feed point of the test voltage and the testing device (30) by opening a service switch (28) and a check is carried out as to whether the voltage in the high-voltage on-board power system (12) drops to zero.

2. Method according to claim 1,
**characterised in that**
a signal is generated when the determined voltage state deviates from the predetermined voltage state.

3. Method according to either claim 1 or claim 2,
**characterised in that**,
when the determined voltage state deviates from the predetermined voltage state, information regarding the deviation is stored in a memory device.

4. Method according to claim 3,
**characterised in that**
the method is carried out automatically before each operation to switch off the high-voltage on-board electrical power system (12).

5. Method according to any of claims 1 to 4,
**characterised in that**
the method is carried out immediately before upcoming maintenance and/or repair work.

6. Method according to any of claims 1 to 5,
**characterised in that**
the test voltage is less than 60 V.

7. Method according to any of claims 1 to 6,
**characterised in that**
the test voltage is provided by a voltage converter (24) from a low-voltage on-board power system (14) of the motor vehicle.

8. Method according to any of claims 1 to 6,
**characterised in that**
the test voltage is provided by an external voltage source which is connected to the high-voltage on-board power system (12) by means of a plug connection which is protected against accidental contact.

9. Method according to any of claims 1 to 6,
**characterised in that**
the test voltage is provided by a pre-charging circuit for an energy storage device of the high-voltage on-board power system (12).

## Revendications

1. Procédé destiné à tester un dispositif de contrôle (30) afin de déterminer un état de tension d'un réseau de bord haute tension (12) d'un véhicule automobile, dans lequel un état hors tension du réseau de bord haute tension (12) est établi et puis, par l'injection d'une tension de contrôle dans le réseau de bord haute tension (12), un état de tension prédéfini est établi dans le réseau de bord haute tension (12), l'état de tension est déterminé au moyen du dispositif de contrôle (30), et l'état de tension déterminé par le dispositif de contrôle (30) est comparé à l'état de tension prédéfini,
**caractérisé en ce que**,
pendant l'injection de la tension de contrôle, un flux de courant est interrompu dans le réseau de bord haute tension (12) entre un point d'injection de la tension de contrôle et le dispositif de contrôle (30) par l'ouverture d'un interrupteur de service (28), et il est vérifié si la tension dans le réseau de bord haute tension (12) tombe à zéro.

2. Procédé selon la revendication 1,
**caractérisé en ce que**,
en cas de divergence entre l'état de tension déterminé et l'état de tension prédéfini, un signal est délivré.

3. Procédé selon une des revendications 1 ou 2,
**caractérisé en ce que**,
en cas de divergence entre l'état de tension déterminé et l'état de tension prédéfini, une information concernant la divergence est enregistrée dans un dispositif de mémoire.

4. Procédé selon la revendication 3,
**caractérisé en ce que**
le procédé est exécuté automatiquement avant chaque processus de coupure du réseau de bord haute tension (12).

5. Procédé selon une des revendications 1 à 4,
**caractérisé en ce que**
le procédé est exécuté immédiatement avant une opération imminente de maintenance et/ou de réparation.

6. Procédé selon une des revendications 1 à 5,
**caractérisé en ce que**
la tension de contrôle est inférieure à 60 V.

7. Procédé selon une des revendications 1 à 6,
**caractérisé en ce que**
la tension de contrôle est fournie au moyen d'un transformateur de tension (24) à partir d'un réseau de bord basse tension (14) du véhicule automobile.

8. Procédé selon une des revendications 1 à 6,
**caractérisé en ce que**
la tension de contrôle est fournie au moyen d'une source de tension externe qui est raccordée au réseau de bord haute tension (12) au moyen d'une connexion protégée contre les contacts accidentels.

9. Procédé selon une des revendications 1 à 6,
**caractérisé en ce que**
la tension de contrôle est fournie au moyen d'un circuit de précharge pour un accumulateur d'énergie du réseau de bord haute tension (12).
